# EUROPEAN PATENT APPLICATION

(11) **EP 4 622 403 A1**
(43) Date of publication of application: **24.09.2025**
(21) Application number: 25163137.0
(22) Date of filing: 12.03.2025
(51) Int. Cl.: H05K 1/11, H01L 23/00, H05K 1/02, H05K 1/14, H05K 3/00, H05K 3/22, H05K 3/24, H05K 3/28, H05K 3/32

(54) **COMPONENT, COMPONENT CARRIER ARRANGEMENT AND METHOD OF MANUFACTURING THE COMPONENT CARRIER**

(30) Priority: 21.03.2024 CN 202410327109
(71) Applicant: AT&S (Chongqing) Company Limited, Chongqing 401133 (CN)
(72) Inventor: LIU, Brad, Chongqing, 401120 (CN); LI, Levi, Chongqing, 401331 (CN); HE, Faye, Chongqing, 401121 (CN); JIANG, Jason, Chongqing, 400000 (CN)
(74) Representative: Donatello, Daniele

(57) **Abstract**

There is described a component carrier, a component carrier arrangement and a method of manufacturing a component carrier. The component carrier (100) has a stack (101),
i) wherein the stack (101) comprises at least one electrically insulating layer structure (120) and at least one electrically conductive layer structure (110) on top of the electrically insulating layer structure (120);
ii) wherein the stack (101) comprises at least one lateral wall (150);
iii) wherein the electrically insulating layer structure (120) comprises a first edge portion (125) defining at least partially the lateral wall (150) of the stack (101); and
iv) wherein the electrically conductive layer structure (110) comprises a second edge portion (115) being offset with respect to the first edge portion (125) towards the inner part of the stack (101), in particular by a distance (D) in the range between 0.05 µm and 15 µm.

## Description

### Field of the Invention

The invention relates to a component carrier having a stack, wherein the stack comprises at least one electrically insulating layer structure and at least one electrically conductive layer structure on top of the electrically insulating layer structure. The electrically insulating layer structure comprises a first edge portion and the electrically conductive layer structure comprises a second edge portion being offset with respect to the first edge portion towards the inner part of the stack. Further, a method to manufacture the component carrier is described.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

However, providing electric connections in the context of a component carrier in an efficient manner may still be considered a challenge, for example regarding precise (micro) dimensions of electrically conductive layer structures. A specific issue in this respect is discussed in the following.

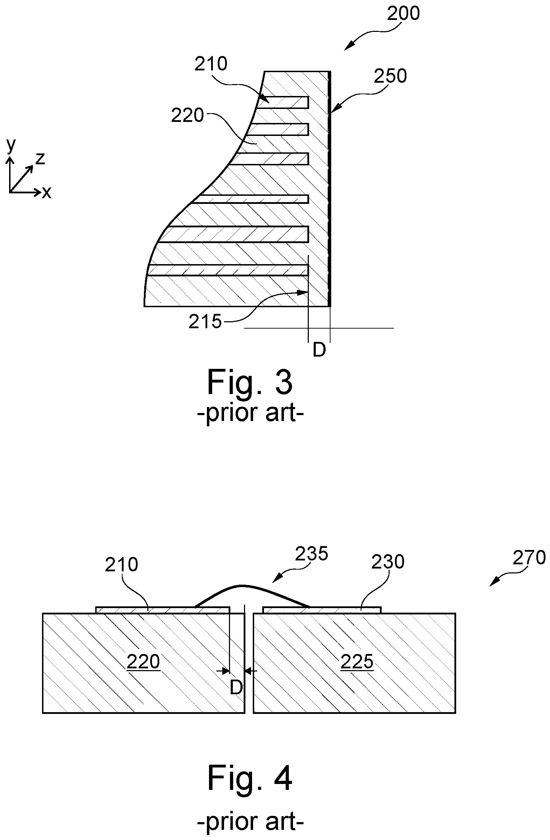

**Figure 3** shows a top view on a conventional circuit board 200. The circuit board 200 comprises an electrically insulating layer 220 and on top a plurality of electrically conductive traces 210. A lateral sidewall of the electrically insulating layer 220 defines a first edge portion 250. Each of the electrically conductive traces 210 defines by its respective lateral sidewall a second edge portion 215 that is offset with respect to the first edge portion 250. The distance D of said offset is conventionally around 150 µm. A certain offset is generally required to enable the application of a protection layer (e.g. a surface finish) that covers not only the upper main surfaces but also the lateral sidewalls of the electrically conductive traces 210.

Conventionally, the first/second edge portion 250/215 is formed by a conventional patterned copper trace manufacture (exposure and development of dry film mask). After the patterning, a routing process is performed. To ensure the non-exposure of copper after routing, a distance of around 150 µm has to be reserved. The precision of distance D may depend on factors such as the accuracy of the routing machine, a wear of the routing bit, a circuit board deformation, an alignment, and the accuracy of the exposure. Said precision may hence be around +/- 150 µm.

**Figure 4** shows a cross-section of a conventional circuit board arrangement 270. The circuit board 220 with the electrically conductive traces 210 on top is arranged side-by-side with a further circuit board 225. The further circuit board 225 comprises on top further electrically conductive traces 230, whereby one of the electrically conductive traces 210 and one of the further electrically conductive traces 230 are electrically connected by a bond wire 235, e.g. a gold wire.

However, due to the additional distance D (around 150 µm), an especially long bond wire 235 has to be applied. Thereby, the efficiency of the electric connection may be decreased, while the manufacture costs may increase (for example gold wire can be expensive).

### Summary of the Invention

There may be a need to provide an electric connection in the context of a component carrier in a (cost-) efficient and reliable manner.

A component carrier, a component carrier arrangement, and a method of manufacturing are described.

According to a first aspect of the invention, there is described a component carrier having a stack,
i) the stack comprises at least one electrically insulating layer structure and at least one electrically conductive layer structure on top of the electrically insulating layer structure,
ii) the stack comprises in particular at least one lateral wall (e.g. defined by a sidewall and/or the vertical extension thereof, can be at least partially a virtual wall),
iii) the electrically insulating layer structure comprises a first edge portion, in particular defining at least partially the lateral wall of the stack (e.g. the sidewall of the electrically insulating layer structure may define the first edge portion and also the lateral wall), and
iv) the electrically conductive layer structure (e.g. a plurality of metal traces) comprises a second edge portion (e.g. the sidewall of the electrically conductive layer structure) being offset with respect to the first edge portion towards the inner part of the stack, in particular by a distance in the range between 0.05 µm and 15 µm.

According to a second aspect of the invention, there is described a component carrier arrangement, comprising:
i) a component carrier as described above, and
ii) a further component carrier, wherein the electrically conductive layer structure and a further electronic conductive layer structure (in particular arranged on top (the main surface) of the further component carrier) (or a further component), arranged on the further component carrier, are electrically connected.

In an example, the further component carrier may comprise a further insulating layer structure and/or a further electrically conductive layer structure (similar or different to the component carrier). In a further example, the stack height of the further component carrier may be similar or different compared to the component carrier.

According to a third aspect of the invention, there is described a method of manufacturing a component carrier, the method comprising:
i) providing a stack that comprises at least one electrically insulating layer structure,
ii) forming an electrically conductive layer structure on top of the electrically insulating layer structure, so that
   a first edge portion of the electrically insulating layer structure and a second edge portion of the electrically conductive layer structure define at least partially the (common) lateral wall of the stack; and
iii) removing a part of the second edge portion of the electrically conductive layer structure, so that the second edge portion is offset with respect to the first edge portion towards the inner part of the stack, in particular by a distance in the range between 0.05 µm and 15 µm.

In the present context, the term "lateral wall" may in particular refer to a portion (region, area, plane) of a (component carrier stack) layer structure that is at least partially exposed at a lateral side, i.e. oriented perpendicular to the main surfaces (directions of main extension) of the component carrier. In other words, a lateral wall may be oriented in at least one spatial direction along the vertical direction (stacking direction). In an example, a sidewall of the stack may be termed lateral wall. In a further example, at least one layer structure (e.g. an electrically insulating layer structure) may define the lateral wall by its sidewall. In an embodiment, the lateral wall may be at least partially seen as an at least partially virtual plane, in particular defined by at least one layer structure (e.g. an electrically insulating layer structure) of the stack. The virtual portion of the lateral wall may be defined by the vertical extension of the lateral wall of at least one layer structure (e.g. an electrically insulating layer structure) of the stack.

In the present context, the term "edge portion" may in particular refer to a portion (region, area, plane) of a (component carrier stack) layer structure that is at least partially exposed. For example, an edge portion may be an external/exposed sidewall (lateral/vertical wall). In a further example, a first edge portion may be a lateral sidewall of an electrically insulating layer structure, in particular oriented perpendicular to an upper/lower main surface of said electrically insulating layer structure. In a further example, a second edge portion may be a lateral sidewall of an electrically conductive layer structure, in particular oriented perpendicular to an upper/lower main surface of said electrically conductive layer structure. In an embodiment, the first edge portion and the second edge portion are (essentially) parallel to each other. In a further embodiment, the first edge portion and the second edge portion are (essentially) parallel to a lateral wall (of the stack). In a further embodiment, the first edge portion and the second edge portion can be inclined with each other by for example 85-95° .

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier.

In an example, all layers of the component carrier may form the stack. In another example, only a part of the layers of the component carrier form the stack.

In this context, the term "layer structure" may in particular refer to a continuous or discontinuous layer (or separated islands within the same plane) of electrically conductive or electrically insulating material. A plurality of such layers, parallel stacked one upon the other, may form the stack in the vertical direction.

According to an exemplary embodiment, the invention may be based on the idea that provide an electric connection in a (cost-) efficient and reliable manner, when an electrically conductive layer structure on top of an electrically insulating layer structure of a component carrier stack is formed, so that an offset between the sidewalls of these layer structures is in the range 0.05 µm to 15 µm (or lower).

Conventionally (see e.g. Figures above), such an offset is much larger, e.g. around 150 µm. This is in particular due to specific factors like the precision of a routing machine. A certain offset may be desired in order to avoid the exposure of metal trace (e.g. copper trace) after the routing process (in terms of extending of the metal trace up to the first edge portion) and enable the application of a further layer structure on top and on the sidewalls of the electrically conductive layer structure, e.g. a surface finish.

It has now been found by the inventors that an extremely small offset distance is actually sufficient to enable a reliable application of a further layer structure. In some embodiments, even an offset distance of lower than 5 µm may be sufficient to fully cover the sidewall (edge portion) of the electrically conductive layer structure.

Providing the short offset distance may provide in particular advantages regarding the electric connection of the electrically conductive layer structure. For example, a bond wire may be made much shorter according to the described disclosure, e.g. when connecting the electrically conductive layer structure to a further electrically conductive layer structure or a component. Thus a compact layout of the component carrier arrangement may be obtained. Additionally or alternatively, material, for example electrically insulating material, may be saved. Further additionally or alternatively, more component carriers may be manufactured within one production format since the design of the component carrier may be more dense.

The described approach may be implemented into existing component carrier production lines in an efficient and straightforward manner. In a preferred embodiment, the short offset distance may be formed by an additional back-etch process. Relics of such an etching process may still be visible in the final component carrier product.

### Exemplary Embodiments

In an embodiment, the distance (D) is less than 5 µm. In an embodiment, the distance (D) is in the range between 0.05 µm and 10 µm. In a further embodiment, the distance (D) is in the range between 0.05 µm and 5 µm. This may provide the advantage that an especially short distance may be provided which is, nevertheless, sufficient for a reliable operation.

In an embodiment, the electrically conductive layer structure comprises a trace portion. Such a trace portion may be applied to transport electric current and/or electric signals. It may be formed for example by providing an electrically conductive layer (e.g. copper), in particular by plating, and then patterning the electrically conductive layer, in particular by etching, to yield the electrically conductive layer structure with the trace portion(s). Such (metal) trace portions may be common in the field of component carriers.

In an embodiment, the electrically conductive layer structure comprises a plurality of trace portions on the surface of the electrically insulating layer structure. In an embodiment, at least two (in particular all) of said plurality of trace portions comprise a respective second edge portion being offset with respect to the first edge portion by a distance in the range between 0.05 µm and 15 µm, in particular in the range between 0.05 µm and 10 µm, more in particular in the range between 0.05 µm and 10 µm. The extremely short distance D may hence apply to a plurality of trace portions. The trace portions may be arranged in parallel with each other and have an (essentially) common second edge portion. This may provide the advantage that the trace portions may be (fully) covered/coated together, in one process step, by at least one external protective/conductive layer structure.

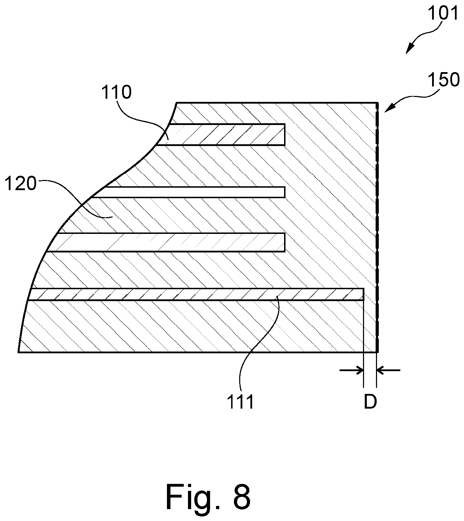

In an embodiment, at least one of the second edge portions (e.g. a first trace portion) is distanced to the first edge portion in the range between 0.05 and 15 µm and at least one further second edge portion (e.g. a second trace portion) is distanced to the first edge portion in the range between 50 and 1000 µm (see e.g. Figure 8). This may bring the advantage of connecting one (or more) trace first, for example a ground or source trace.

In an embodiment, the second edge portions of said at least two of said plurality of trace portions facing the same lateral wall are parallel one to each other. In an embodiment, the second edge portions of said at least two of said plurality of trace portions are misaligned with respect to each other by a distance of 3 µm or lower, in particular in a range between 0,05 µm and 3 µm. Thus, structural feature may reflect a manufacturing process that comprises an etching step. In other words, the (actually undesired) misalignment may show that the short offset distance has been provided by etching the electrically conductive layer structure (at the second edge portion).

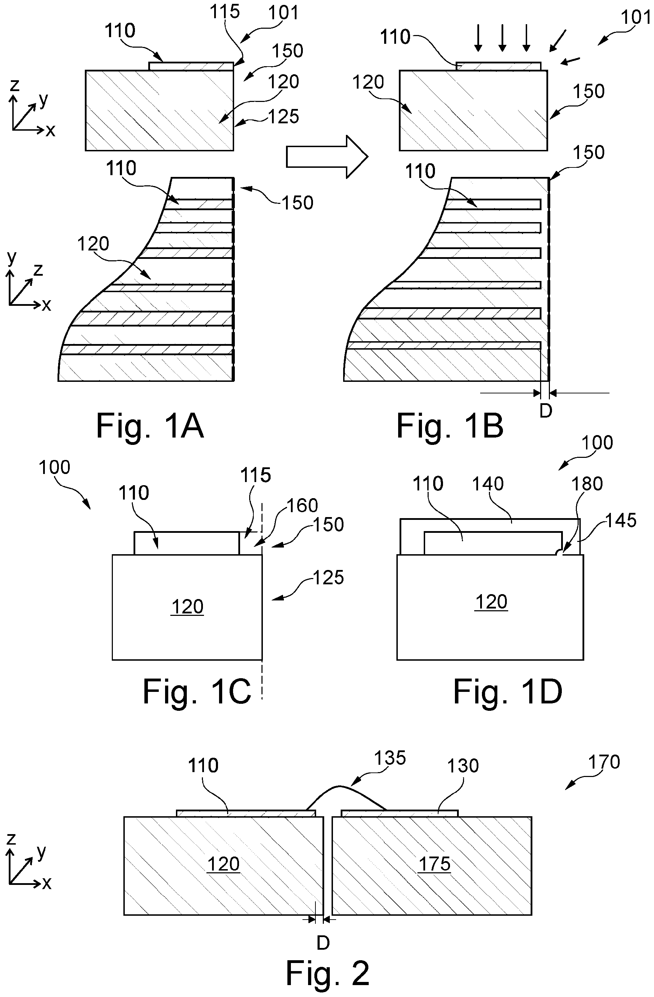

In an embodiment, at least one of the traces is broader than another one of the traces (different broadness of trace portions). This can be seen for example in Figures 1A and 1B. A broader trace may deliver in particular power, whereas a more narrow trace may be used to transmit electrical signals.

In an embodiment, the electrically conductive layer structure/second edge portion may be connected to a pad and/or comprise a pad. This may simplify the electric connection, e.g. with a bond wire and/or solder ball.

In an embodiment, the electrically conductive layer structure comprises a multiple layer structure (for example two or more layer structures). These layer structures may be similar or different in at least one of material, thickness, chemical/physical properties.

In an embodiment, an external protective layer structure at least partially covers an internal electrically conductive layer structure (on top of the stack). The external protective layer structure may comprise an electrically conductive material (this may be the external electrically conductive layer structure described below) or an electrically insulating material. The external protective layer structure may comprise for example a coating or an ink. Thereby, an efficient protection may be provided for the electrically conductive layer structure, in particular for the individual traces.

In an embodiment, the component carrier further comprises an external electrically conductive layer structure, in particular a surface finish, arranged on top of the electrically conductive layer structure. A surface finish may be an established and reliable material from the field of component carriers that protects the electrically conductive layer structure, in particular individual traces, from abrasion and/or corrosion.

In an embodiment, the external electrically conductive layer structure and/or the external protective layer structure defines a third edge portion and/or the (entirely or partially) external planar surface of the electrically conductive layer structure. In other words, a sidewall of the external protective/conductive layer structure may define a third edge portion being (essentially) parallel to the first edge portion and the second edge portion. Accordingly, there may also be a second offset distance between the third edge portion and the first edge portion and a third offset distance between the third edge portion and the second edge portion.

In an example, the second offset distance may be smaller than the third offset distance. Alternatively, the second offset distance may be larger than the third offset distance. In an example, the second offset distance and/or the third offset distance may be in the range from 0.1 µm to 13 µm, in particular in the range from 0.5 µm to 10 µm.

In an embodiment the external electrically conductive layer structure covers the entire side wall and/or entire surface of the electrically conductive layer structure. Thereby, a robust (mechanical and/or chemical) protection may be enabled. Specifically, it should be noticed that such a robust protection may be provided even though the offset distance (edge region) is extremely short/small.

In an embodiment, the external electrically conductive layer structure comprises at least one of nickel, palladium, gold, in particular comprises an ENEPIG layer structure. Hence, established and economically important surface finishes may be directly applied within the same component carrier manufacture process.

In an embodiment, a thickness of the electrically conductive layer structure, in particular of the external electrically conductive layer structure, is lower at the second edge portion than at an adjacent portion of the second edge portion. In other words, the (external) electrically conductive layer structure comprises a lower thickness at a lower portion (along the stack thickness direction) than at the corner portion. In a preferable embodiment, the external electrically conductive layer structure may be protruded/rounded at the corner portion.

In an embodiment, the surface finish layer structure may comprise a thickness in the range 0.5 µm to 1.5 µm, in particular around 0.8 µm.

In an embodiment, the component carrier further comprises an undercut at the extremity of the second edge portion (along the stack thickness direction) of the electrically conductive layer structure in contact with the electrically insulating layer structure. Such an undercut may be a structural feature that is a result from an etching process. For example, the short offset distance may be realized by a specific etching process, being reflected by the presence of one or more undercut structures. An undercut may also be termed an indentation or a recess, for example with respect to the electrically conductive layer structure sidewall (second edge portion).

In an embodiment, the undercut is at least partially filled by material of the electrically insulating layer structure. Additionally or alternatively, the undercut is at least partially filled by material of the electrically conductive layer structure and/or the external electrically conductive layer structure. Thereby, the adhesion capability and stability may be improved (e.g. compared to a void undercut). The material of the electrically insulating layer structure may be uncured or not fully cured, so that a portion of said material may flow into the undercut. In a further embodiment, material of the external protective/conductive layer structure may (at least partially) fill the undercut.

In an embodiment, a roughness of the vertical surface of the second edge portion is different, in particular lower, than a roughness of the electrically conductive layer structure at the surface that is in contact with the electrically insulating layer structure. The latter may be especially rough to enable a better adhesion to insulating resin material.

In an embodiment, the roughness of the surface of the electrically conductive layer structure that is in contact with the electrically insulating layer structure is different, in particular higher, than the roughness of the other external surfaces of the electrically conductive layer structure. The former may be especially rough to enable a better adhesion to insulating resin material.

In an embodiment, the roughness of the surface of the external electrically conductive layer structure and/or the external protective layer structure is higher than the roughness of the vertical surface of the second edge portion.

At least one of these three embodiments may illustrate that the (vertical) sidewall of the electrically conductive layer structure (at the second edge portion) is smooth or at least less rough than other surfaces of the electrically conductive layer structure. This may be a direct result of an etching process being performed with respect to the (second edge portion of) electrically conductive layer structure.

In an embodiment, the electrically conductive layer structure is embedded in a further electrically insulating layer structure, in particular a solder resist layer structure. Thereby, a further protection (e.g. against abrasion/corrosion) may be provided and/or the surface may be prepared for a subsequent solder process.

In an embodiment, the further electrically insulating layer structure covers at least partially an edge region at the second edge portion. The term "edge region" may in this context refer to a region (e.g. like a square/cube) defined by the offset distance D and the second edge portion or the third edge portion.

The further electrically insulating layer structure may cover the electrically conductive layer structure and/or the external protective/conductive layer structure, in particular also at the sidewall (second/third edge portion). Thereby, an efficient protection, in particular between trace portions, may be enabled.

In an embodiment, the electrically conductive layer structure is the outermost electrically conductive layer structure of the stack.

In an embodiment, the electrically conductive layer structure is at least partially exposed on the external surface of the stack.

In other words, the described disclosure may refer (only) to the external (main) surface of the stack, and not to layer structures buried/embedded in the stack. This may simplify a coupling with a connection structure, for example a wire bond, since the electrically conductive layer structure is free from insulating material (at least at a portion) and is directly electronic connectable.

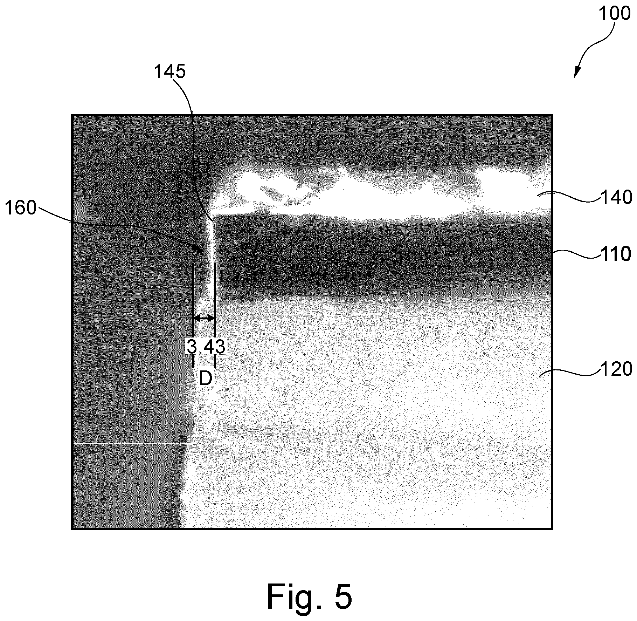

In an embodiment, the first edge portion of the electrically insulating layer structure is inclined with respect to the second edge portion of the electrically conductive layer structure along the stack thickness direction (Z) (see e.g. Figure 5). This structural feature may be a relic from a manufacture step, e.g. by drilling or routing. This may provide the advantage that a common and straightforward process may be directly used for a first (coarse) material removal.

In an embodiment, the second edge portion follows the direction of the stack thickness (Z), in particular is perpendicular with respect to one main surface of the stack. This may minimize the surface area of the sidewall of the second edge portion in thickness direction and thus may be less prone to surface oxidation compared to an inclined sidewall extension.

In an embodiment, the second edge portion comprises a straight (vertical/lateral) sidewall. Such a straight (and smooth) sidewall may be a direct result from an etching process, applied to remove material in a second (fine) material removal step.

In an embodiment, the component carrier further comprises an electronic component, in particular at least partially embedded in the stack, and electrically connected to the electrically conductive layer structure. This may provide the advantage that the electrically conductive layer structure (in particular individual traces) can be electrically connected in a design-flexible manner, without requiring additional space (in particular since the offset distance is extremely short).

In an embodiment, the electrically conductive layer structure and the electronic component are electrically connected by a bond wire, in particular a gold-wire. Thereby, an efficient and reliable electric connection may be provided in a straightforward manner. Yet, such a wire, in particular if a valuable material like gold is used, may be expensive. With the described short offset distance, material costs may be saved.

In an embodiment, a surface of the electrically insulating layer structure is in the same (or a different) plane (in other words: flush) with a surface of the electronic component. This architecture may enable a short bond wire and efficient electric connection.

In an embodiment, the electrically conductive layer structure and the further electronic conductive layer structure (or the further component) are electrically connected by a bond wire, in particular a gold-wire. Thereby, an efficient and reliable electric connection may be provided in a straightforward manner. Yet, such a wire, in particular if a valuable material like gold is used, may be expensive. With the described short offset distance, material costs may be saved.

In an embodiment, a surface of the electrically conductive layer structure is in the same (or a different) plane (in other words flush) with a further surface of the further electronic conductive layer structure (or the further component). This architecture may enable a short bond wire and efficient electric connection.

In an embodiment, the first edge portion and/or the second edge portion is/are formed by removal of at least part of the electrically conductive layer structure and/or the electrically insulating layer structure. Using a material removal step, the stack may be (at least partially) formed into the desired shape/dimension.

In an embodiment, removing a part (of the first edge portion) comprises a cutting process, in particular routing and/or drilling. This may provide the advantage that an efficient material removal may be done in a straightforward manner using established component carrier technology.

In an embodiment, removing a part of the second edge portion comprises an etching process. It has been surprisingly found that a (back) etching may be an especially accurate approach to form the advantageous short offset distance.

In an embodiment, before surface finish (e.g. gold-plating), there is a pre-treatment which refers to the "etching back" of metal/copper, including the cleaning and smoothing of the metal surface (to reach a smaller roughness). The parameters of the pre-treatment may be adjusted to have the desired offset distance, for example apply a larger etching quantity.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semiconducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained. After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figures 1A to 1D show a component carrier and a manufacture method, according to exemplary embodiments of the invention.
Figure 2 shows a cross-section of a component carrier arrangement, according to an exemplary embodiment of the invention.
Figure 3 shows a top view on a conventional circuit board.
Figure 4 shows a cross-section of a conventional circuit board arrangement.
Figures 5 to 7 respectively show photographic images of cross-sections through a component carrier, according to exemplary embodiments of the invention.
Figure 8 shows a top view on the component carrier stack 101 after a manufacture step, according to an exemplary embodiment of the invention.

### Detailed Description of the Drawings

**Figure 1A** shows a cross-section of the component carrier stack 101 and a top view on the component carrier stack 101 after a first manufacture step, according to an exemplary embodiment of the invention. The first manufacturing step may comprise the exposure/development of the electrically conductive layer structure 110 (metal trace), and the routing process of the component carrier stack 101, so that the edge of the electrically conductive layer structure 110 is flush with the edge of the component carrier 101. The stack 101 comprises an electrically insulating layer structure 120 and an electrically conductive layer structure 110 on top of the electrically insulating layer structure 120. The electrically conductive layer structure 110 comprises hereby a plurality of parallel metal traces. The metal traces may comprise copper and/or chromium and/or nickel. Alternatively, the electrically conductive layer structure 110 may comprise carbon, for example graphene or PEDOT.

A first edge portion 125 defined by the lateral sidewall of the electrically insulating layer structure 120 and a second edge portion 115 defined by the lateral sidewall of the electrically conductive layer structure define together a common (flush) lateral wall 150 of the stack 101.

**Figure 1B** shows a cross-section of the component carrier stack 101 and a top view on the component carrier stack 101 after a second manufacture step, according to an exemplary embodiment of the invention.

In comparison to the example of Figure 1A, a part of the second edge portion 115 of the electrically conductive layer structure 110 has been removed, so that the second edge portion 115 is offset with respect to the first edge portion 125 towards the inner part of the stack 101.

Both, the first edge portion 125 and the second edge portion 115, are formed by removal of part of the electrically conductive layer structure 110 and the electrically insulating layer structure 120. In a first (coarse) material removal step, removal has been done by a cutting process such as a routing process (as in Figure 1A).

However, in comparison to conventional approaches, a second (fine) material removal step has been performed starting with the stack 101 of Figure 1A. In this second (fine) material removal step, only a part of the second edge portion 115 is removed, in a preferred embodiment with a back-etching process. Alternatively, the second material removal step may comprise one of plasma etching, laser ablation and/or mechanical drilling.

As a result, in this preferred embodiment, the distance D between the first edge portion 115 and the second edge portion 125 is significantly shortened and in the range between 0.05 µm and 5 µm. Alternatively, the distance between the first edge portion 115 and the second edge portion 125 may be in the smaller than 1000 µm in particular smaller than 500 µm. It is schematically shown in the Figures that this extremely short distance D holds true for all the parallel electrically conductive trace portions of the electrically conductive layer structure 110.

**Figure 1C** shows a cross-section (side view) through a component carrier 100, according to an exemplary embodiment of the invention. This cross-section corresponds to the one of Figure 1B, but it is further indicated that the lateral wall 150 can be understood as a (virtual) plane that extends in parallel to or flush with the electrically insulating layer structure 120 sidewall and in parallel to or flush with the first edge portion 125. The second edge portion 115 and the lateral wall 150 can thus define the indicated edge region 160. Said edge region 160 may be used to apply a further layer structure on top of the electrically conductive layer structure 110.

**Figure 1D** shows a cross-section (side view) through a component carrier 100, according to a further exemplary embodiment of the invention. An external protective layer structure has been applied which is in the present example an external electrically conductive layer structure 140, specifically a surface finish. The external electrically conductive layer structure 140 is arranged on top of the electrically conductive layer structure 110 (e.g. by plating, immersion, etc.). Besides the upper main surface of the electrically conductive layer structure 110, also the entire sidewalls of the electrically conductive layer structure 110 have been covered by the external electrically conductive layer structure 140. The external electrically conductive layer structure 140 comprises for example an ENEPIG layer structure.

In comparison to Figure 1C, it can be seen that the edge region 160 has been (partially) filled with said external electrically conductive layer structure 140. The external electrically conductive layer structure 140 defines a third edge portion 145 and the external planar surface of the electrically conductive layer structure 110.

The external electrically conductive layer structure 140 comprises a lateral wall which is in parallel to or flush with the (sidewall of the) electrically insulating layer structure 120. The lateral wall of the external electrically conductive layer structure 140 may be described as third edge portion (third offset).

Further, an undercut 180 structure can be seen at the extremity of the second edge portion 115 of the electrically conductive layer structure 110 in contact with the electrically insulating layer structure 120. The undercut 180 is in this example filled by material of the electrically insulating layer structure 120 and/or with material of the external electrically conductive layer structure 140. Such an undercut 180 may be a relict of the above identified etching process, used to from the second edge portion 115.

**Figure 2** shows a cross-section through a component carrier arrangement 170, according to an exemplary embodiment of the invention. On the left side, the above described component carrier 100 can be seen. On the right side, there is arranged a further component carrier 175 with a further electrically conductive layer structure 130 arranged on top. The electrically conductive layer structure 110 of the component carrier 120 and the further electrically conductive layer structure 130 of the further component carrier 175 are at the same (or different) vertical level and electrically connected by a bond wire 135. The further component carrier 175 can have the same or a different amount of electrically conductive layers and/or electrically insulating layers.

In comparison to the prior art example (see Figure 4 above), the offset distance D between the first edge portion 125 and the second edge portion 115 is much shorter (e.g. lower than 5 µm). Thus, a much shorter bond wire 135 can be applied, thereby saving costs while making the electric connection more efficient. Besides, the signal loss can be significantly reduced.

**Figure 5** shows a photographic image of a cross-section through a component carrier 100, according to an exemplary embodiment of the invention. The Figure is comparable to Figure 1D. It can be seen that the offset distance D is only 3.43 µm. The external electrically conductive layer structure 140 is much thicker on top of the electrically conductive layer structure 110 than at the sidewall of the electrically conductive layer structure 110, where the external electrically conductive layer structure 140 defines the third edge 145.

It can be seen that a small offset distance of only 3.43 µm is sufficient to enable an efficient and robust protection of the electrically conductive layer structure 110 by the external electrically conductive layer structure 140.

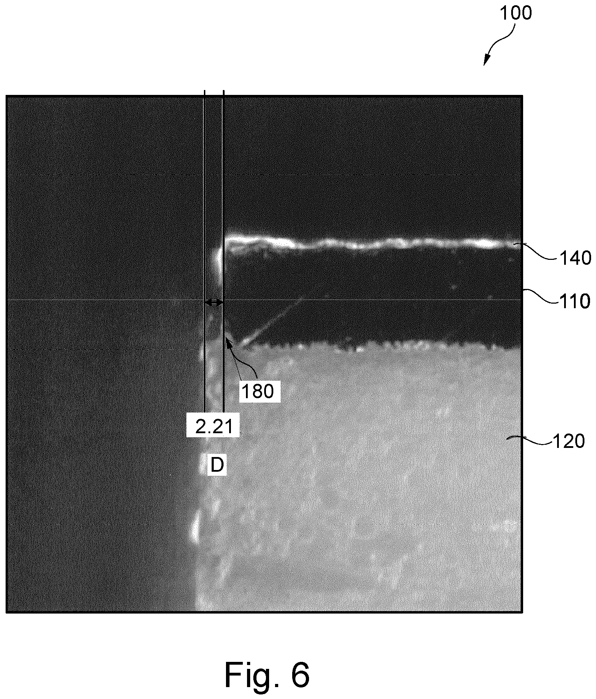

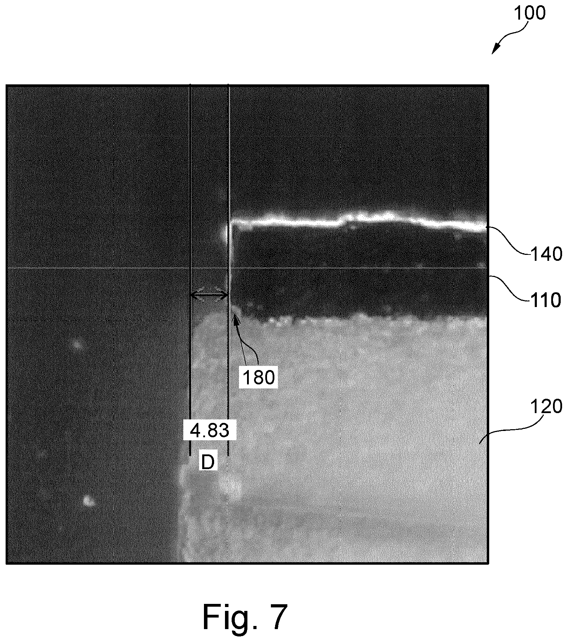

It can be further seen (compare also Figures 6 and 7) that the second edge portion 115 surface is smooth compared to the other surfaces:
i) the roughness of the vertical surface of the second edge portion 115 is lower, than a roughness of the electrically conductive layer structure 110 at the surface that is in contact with the electrically insulating layer structure 120.
ii) the roughness of the surface of the electrically conductive layer structure 110 that is in contact with the electrically insulating layer structure 120 is higher, than the roughness of the other external surfaces of the electrically conductive layer structure 110, and
iii) the roughness of the surface of the external electrically conductive layer structure 140 is higher than the roughness of the vertical surface of the second edge portion 115.

Additionally, the second edge portion 115 comprises a straight sidewall. The first edge portion 125 of the electrically insulating layer structure 120 is slightly inclined with respect to the second edge portion 115 of the electrically conductive layer structure 110 along the stack thickness direction (Z).

**Figures 6** **and** **7** show photographic images of a cross-section through a component carrier 100, according to exemplary embodiments of the invention, comparable with the one shown in Figure 5. Yet, in Figures 6 and 7, the undercut 180, filled with electrically insulating material from the electrically insulating layer structure 120 (alternatively electrically conductive material), can be clearly seen. While the offset distance D is 2.21 µm in Figure 6, said distance D is 4.83 µm in Figure 7.

In this example, a thickness of the electrically conductive layer structure and/or the external electrically conductive layer structure 140 is lower at the second edge portion 115 than at an adjacent portion of the second edge portion 115 (thickness getting lower towards the inner part of the stack 101).

**Figure 8** shows a top view on the component carrier stack 101 after a manufacture step, according to an exemplary embodiment of the invention. In an embodiment, one of the second edge portions (a further trace portion) is distanced to the first edge portion in the range between 0.05 and 15 µm and the further second edge portions (trace portions) are distanced to the first edge portion in the range between 50 and 1000 µm. This may bring the advantage of connecting one trace first, for example a ground or source trace.

### Reference signs

- 100: Component carrier
- 101: Stack
- 110: Electrically conductive layer structure, traces
- 111: Electrically conductive layer structure, further trace
- 115: Second edge portion
- 120: Electrically insulating layer structure
- 125: First edge portion
- 130: Further electrically conductive layer structure
- 135: Bond wire
- 140: External electrically conductive/protective layer structure
- 145: Third edge portion
- 150: Lateral wall of stack
- 160: Edge region
- 170: Component carrier arrangement
- 175: Further component carrier
- 180: Undercut

## Claims

1. A component carrier (100) having a stack (101),
wherein the stack (101) comprises at least one electrically insulating layer structure (120) and at least one electrically conductive layer structure (110) on top of the electrically insulating layer structure (120);
wherein the stack (101) comprises at least one lateral wall (150); wherein the electrically insulating layer structure (120) comprises a first edge portion (125) defining at least partially the lateral wall (150) of the stack (101); and
wherein the electrically conductive layer structure (110) comprises a second edge portion (115) being offset with respect to the first edge portion (125) towards the inner part of the stack (101) by a distance (D) in the range between 0.05 µm and 15 µm.

2. The component carrier (100) according to claim 1,
wherein the electrically conductive layer structure (110) comprises a trace portion on the surface of the electrically insulating layer structure (120), in particular
wherein the electrically conductive layer structure (110) comprises a plurality of trace portions on the surface of the electrically insulating layer structure (120), and
wherein at least two of said plurality of trace portions comprise a respective second edge portion (115) being offset with respect to the first edge portion (125) by a distance (D) in the range between 0.05 µm and 15 µm.

3. The component carrier (100) according to any one of the preceding claims, wherein the electrically conductive layer structure (110) comprises a multiple layer structure,
in particular with an external protective layer structure that at least partially covers an internal electrically conductive layer structure (110).

4. The component carrier (100) according to any one of the preceding claims, wherein the component carrier (100) further comprises:
an external electrically conductive layer structure (140), in particular a surface finish, arranged on top of the electrically conductive layer structure (110), in particular
wherein the external electrically conductive layer structure (140) defines a third edge portion (145) and/or the external planar surface of the electrically conductive layer structure (110); and/or
wherein the external electrically conductive layer structure (140) covers the entire side wall and/or entire surface of the electrically conductive layer structure (110).

5. The component carrier (100) according to any one of the preceding claims,
wherein a thickness of the electrically conductive layer structure (110), in particular of the external electrically conductive layer structure (140), is lower at the second edge portion (115) than at an adjacent portion of the second edge portion (115).

6. The component carrier (100) according to any one of the preceding claims, wherein the component carrier (100) further comprises:
an undercut (180) at the extremity of the second edge portion (115) of the electrically conductive layer structure (110) in contact with the electrically insulating layer structure (120), in particular wherein the undercut (180) is at least partially filled by material of the electrically insulating layer structure (120).

7. The component carrier (100) according to any one of the preceding claims,
wherein a roughness of the vertical surface of the second edge portion (115) is different, in particular lower, than a roughness of the electrically conductive layer structure (110) at the surface that is in contact with the electrically insulating layer structure (120).

8. The component carrier (100) according to any one of the preceding claims,
wherein the electrically conductive layer structure (110) is the outermost electrically conductive layer structure of the stack (101); and/or wherein the electrically conductive layer structure (110) is at least partially exposed on the external surface of the stack (101).

9. The component carrier (100) according to any one of the preceding claims,
wherein the first edge portion (125) of the electrically insulating layer structure (120) is inclined with respect to the second edge portion (115) of the electrically conductive layer structure (110) along the stack thickness direction (Z).

10. The component carrier (100) according to any one of the preceding claims,
wherein the second edge portion (115) follows the direction of the stack thickness (Z), in particular is perpendicular with respect to one main surface of the stack, in particular
wherein the second edge portion (115) comprises a straight vertical sidewall.

11. The component carrier (100) according to any one of the preceding claims, wherein the component carrier (100) further comprises:
an electronic component, in particular at least partially embedded in the stack (101), and electrically connected to the electrically conductive layer structure (110), in particular
wherein the electrically conductive layer structure (110) and the electronic component are electrically connected by a bond wire (135), more in particular a gold-wire.

12. The component carrier (100) according to claim 11,
wherein a surface of the electrically insulating layer structure (120) is in the same plane with a surface of the electronic component.

13. A component carrier arrangement (170), comprising:
a component carrier (100) according to any one of the preceding claims; and
a further component carrier (175);
wherein the electrically conductive layer structure (110) and a further electronic conductive layer structure (130), provided on the further component carrier (175), are electrically connected, in particular wherein the electrically conductive layer structure (110) and the further electronic conductive layer structure (130) are electrically connected by a bond wire (135), in particular a gold-wire; and/or
wherein a surface of the electrically conductive layer structure (110) is in the same plane with a further surface of the further electronic conductive layer structure (130).

14. A method of manufacturing a component carrier (100), the method comprising:
providing a stack (101) that comprises at least one electrically insulating layer structure (120);
forming an electrically conductive layer structure (110) on top of the electrically insulating layer structure (120), so that
a first edge portion (125) of the electrically insulating layer structure (120) and a second edge portion (115) of the electrically conductive layer structure (110) define at least partially the lateral wall (150) of the stack (101); and
removing a part of the second edge portion (115) of the electrically conductive layer structure (110), so that the second edge portion (115) is offset with respect to the first edge portion (125) towards the inner part of the stack (101) by a distance (D) in the range between 0.05 µm and 15 µm.

15. The method according to claim 14,
wherein removing a part comprises a cutting process, in particular routing and/or drilling, and/or
wherein removing a part of the second edge portion (115) comprises an etching process.
